# EUROPEAN PATENT SPECIFICATION

(11) **EP 1 764 617 B1**
(45) Date of publication and mention of the grant of the patent: **27.05.2009**
(21) Application number: 06018110.4
(22) Date of filing: 30.08.2006
(51) Int. Cl.: G01P 1/02, G01P 15/08, B81B 7/00, G01L 19/06

(54) **Displacement detection device with overrange protection**
Verschiebungsdetektor mit Schutz vor zu starker Auslenkung
Capteur de déplacement avec élément de protection contre déplacement excessif

(30) Priority: 16.09.2005 JP 2005270434
(43) Date of publication of application: 21.03.2007
(73) Proprietor: HITACHI METALS, LTD., Minato-ku, Tokyo 105-8614 (JP)
(72) Inventor: Takada, Yoshiaki, Mohka, 321-4333 (JP); Ochiai, Hideyuki, Hino, 191-0002 (JP); Nishino, Keiichi, Mohka, 321-4362 (JP); Saitoh, Masakatsu, Yokohama, 240-0026 (JP)
(74) Representative: Beetz & Partner

(56) References cited:
- EP-A- 1 477 818
- EP-A1- 0 886 144
- JP-A- 6 242 141
- US-A- 5 734 106
- US-B1- 6 435 028

## Description

### BACKGROUND OF THE INVENTION

### 1. Field of the Invention

The present invention relates to a small-sized and highly sensitive displacement detection device, applicable to an acceleration sensor, a pressure sensor, a gyro-sensor and the like, that is made by a semiconductor production technology, particularly to a displacement detection device comprising a displacement detection element with a flexibly deformable portion and an IC chip.

### 2. Description of the Related Art

The MEMS (Micro-Electro-Mechanical-System) technology, which manufactures solid fine structures having a mechanical function and an electric function on a semi-conductive substrate by combining a semiconductor production process technology with a machining technology and/ or a material technology, has been applied to widely various fields. Particularly, it has been applied to small-sized and highly sensitive sensor fields, such as an acceleration sensor, a pressure sensor, a gyro-sensor. These sensors, whose flexibly deformable portions are made by the MEMS technology, transform displacements of the flexibly deformable portions into electro-signals by a piezo resistor etc. to detect the displacements. Structures of the flexibly deformable portions may be different depending on applications of the displacement detection devices, but they all transform displacements of the flexibly deformable portions into electro-signals and are called, for example, an acceleration sensor or a pressure sensor according to causes of displacements of the flexibly deformable portions.

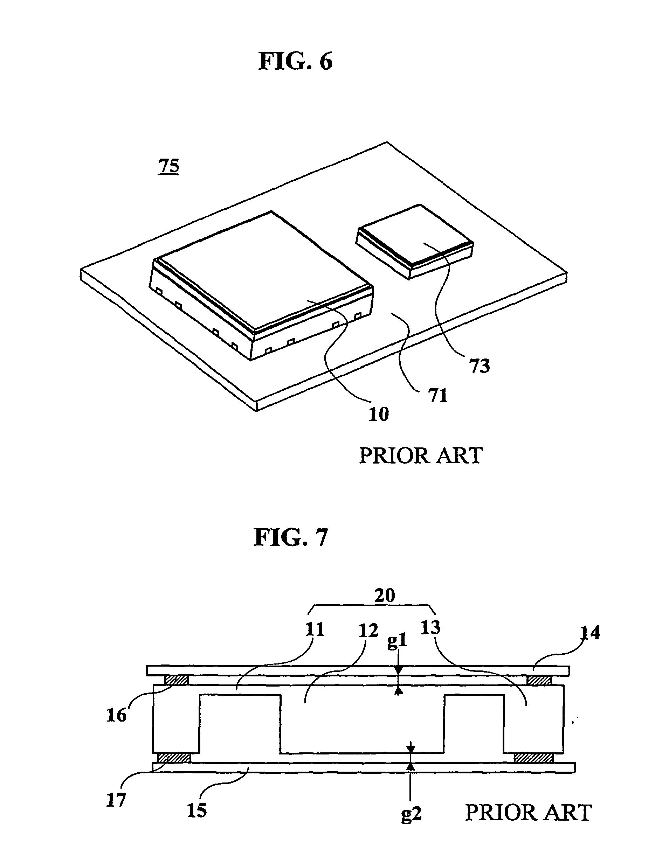

Transformation devices for deforming flexibly deformable portions into electro-signals include piezo resistors, electro-static capacitors, strain gauges etc. Whatever used, their output voltages are as small as some mV to some tens mV. By the reason, it is necessary that a circuit for amplifying their output voltages is assembled with them in a wide variety of applications, such as automotive, aircrafts, mobile terminals and toys. An acceleration sensor apparatus disclosed in Japanese Laid-open Patent 2003-28891 is shown in an appearance perspective view of FIG. 6. In the acceleration sensor apparatus 75 of FIG. 6, an acceleration sensor 10 and an IC 73 having an amplifier is assembled on a base plate 71. But, it is hard to miniaturize an acceleration sensor apparatus in such a structure.

Sensitivity and impact resistance may be changed by a shape of a flexibly deformable portion formed on a silicon substrate by the MEMS technology. Generally speaking, the impact resistance is enhanced when the flexibly deformable portion is made thicker, but the sensitivity is reduced. By contrast, when the flexibly deformable portion is made thinner to obtain a desirable sensitivity, the sensitivity is enhanced but the impact resistance lowers. It is difficult to satisfy both the good sensitivity and the good impact resistance. An acceleration sensor, which has a regulation plate to restrict a movement of a flexibly deformable portion within a predetermined extent even when an excessive external force is applied to the flexibly deformable portion, is described in Japanese Laid-open Patents Hei 4-274005 and Hei 8-233851.

An acceleration sensor having such a regulation plate is shown in FIG. 7. An acceleration sensor element 20 has flexibly deformable portions 11, a weight 12 and a support frame 13 made of silicon. Piezo resistors, though they are not shown, are provided on the flexibly deformable portions 11. When acceleration is applied to the acceleration sensor element 20, the weight 12 is vibrated up and down, or left and right, so that the flexibly deformable portions 11 are deformed or displaced to change resistance of the piezo resistors, and the resistance change is transformed into electro-signal for output. Regulation plates 14, 15 are bonded above and below the support frame 13 by adhesive 16, 17. The deformation of the flexibly deformable portions is restricted within a gap g1 between a top surface of the acceleration sensor element 20 and a bottom surface of the regulation plate 14 and within a gap g2 between a bottom surface of the weight 12 and a top surface of the regulation plate 15. When an excessive external force is applied, the top surface of the acceleration sensor element of the bottom surface of the weight contacts the regulation plates that do not provide the flexibly deformable portions deformation more than g1 or g2 to prevent the flexibly deformable portions from damaging and to enhance the impact resistance of the acceleration sensor element.

An acceleration sensor example more miniaturized by using an IC chip for a regulation plate instead of a silicon plate and a soda-lime glass is described in Japanese Laid-open Patent 2005-169541. The Japanese Patent Document discloses a structure, in which an IC chip is used for a regulation plate facing a top surface of an acceleration sensor element. The regulation plate 14 of FIG. 7 is replaced with an IC chip. By using the IC chip for a regulation plate, reduction in part number and miniaturization have been accomplished. Also, taking advantages of the IC chip disposed close to the acceleration sensor element, a temperature compensation circuit for piezo resistors and others are incorporated into the IC chip to realize a more sensitive acceleration sensor.

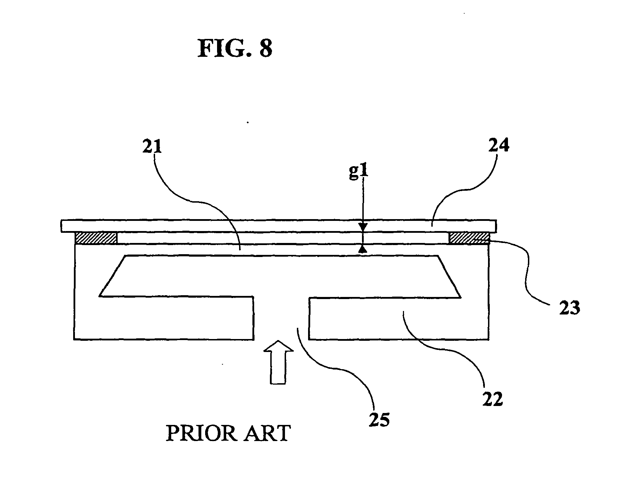

And, Japanese Laid-open Patent 2005-169541 describes a pressure sensor using an IC chip for a regulation plate. Its schematic structure is shown in a cross-sectional view of FIG. 8. An air pressure is applied as shown by an arrow through an opening 25 disposed below a pressure vessel composed of a flexibly deformable portion 21 and a solid portion 22 to deform the flexibly deformable portion 21 as if it is expanded above. The displacement is transformed into electro-signal by a detector (not shown), such as a piezo-resistor located on the flexibly deformable portion 21. When an excessive pressure is applied to the flexibly deformable portion, a top of the flexibly deformable portion 21 contacts a bottom of the IC chip 24 so that the flexibly deformable portion 21 is not deformed more than a gap g1 to prevent damage of the flexibly deformable portion and to accomplish an impact-resistant pressure sensor element. The gap between the top of the flexibly deformable portion 21 and the bottom of the IC chip 24 is made by adhesive 23 containing spacers.

Impact resistance in a displacement detection device has been enhanced by making a regulation plate restrict deformation of a flexibly deformable portion, and a small-sized and highly sensitive displacement detection device has been realized by using an IC chip for the regulation plate. For example, EP 1477818 A discloses an acceleration sensor in which an IC chip is used as an upper regulation plate. The IC chip, the rear surface of which without an IC circuit has been grinded to 0.3 mm thick, is fixed by bonding at each corner to a support frame of the acceleration sensor. However, among a number of displacement detection devices manufactured, displacement detection devices that have an operation problem due to silicon broken pieces caused from IC chips have occurred, though it was a very low happening frequency. By disassembling and investigating the displacement detection devices that had the operation accident, it has been revealed that silicon broken pieces are trapped into gaps between the flexibly deformable portions and the IC chips to obstruct movements of the flexibly deformable portions. It was confirmed by comparing the silicon broken pieces trapped into the gaps with cracks on side ridges of the IC chips that the silicon broken pieces were caused from the IC chips.

In a displacement detection device, a displacement detection element and an IC chip bonded to the displacement detection element are housed in a protection case. Silicon broken pieces caused from the IC chip are confined in the protection case, move around in the protection case, and are trapped into gaps between the flexibly deformable portion of the displacement detection element and the IC chip, and the trapped silicon broken pieces obstruct the movement of the flexibly deformable portions.

IC chips are obtained by dicing an IC wafer. Chippings caused on side ridges of the IC chips were not minded as long as they did not affect the IC circuits. Also, if silicon broken pieces are completely removed from the IC chips, the silicon broken pieces are not trapped in the gaps between the flexibly deformable portions and the IC chips nor disturb movement of the flexibly deformable portions. Chippings at issue are loose chippings, which remain at defected portions, that is, silicon broken pieces partially held by the IC substrates. During assembling and/or using the displacement detection devices, silicon broken pieces drop from loose chippings and affect properties of the displacement detection devices.

### SUMMARY OF THE INVENTION

The present invention has been made to solve the above-mentioned problem and has an object to provide an IC chip, used for a regulation plate for restricting deformation of a flexibly deformable portion of a displacement detection device, which does not have loose chippings.

A displacement detection device according to the present invention comprises: a displacement detection element having a flexibly deformable portion to be deformed by an external force and measuring a displacement of the flexibly deformable portion to emit a detection signal; an IC chip having an electronic circuit for electrically processing the detection signal from the displacement detection element and disposed for a rear surface of the IC chip to face the flexibly deformable portion with a predetermined gap from the flexibly deformable portion to mechanically prevent the flexibly deformable portion from excessively deforming; and
a protection case housing the displacement detection element and the IC chip;
wherein the rear surface of the IC chip has grinding traces at an angle of 0 to 45 degrees with a vertical line on side ridges of the IC chip.

Grinding direction on the rear surface of the IC chip is the same as that of grinding traces left on the IC chip. The direction is defined by an angle of the grinding traces with a vertical line on a side ridge of the IC chip. The angle of 45 degrees means the direction at an angle of +/- 45 degrees with the vertical line. In other words, the grinding traces are at an angle of 45 degrees or 135 degrees with the vertical line. The grinding direction (grinding traces) at an angle of 0 to 45 degrees with a vertical line with the side ridges minimizes chipping appearance ratio including loose chippings on the side ridges.

Silicon wafers, for manufacturing IC's, having 525 µm thick and 625 µm thick are mainly used, and their front surfaces are mirror-polished, while their rear surfaces are polished to such an extent that the surfaces can be suctioned by vacuum. IC wafers are ground on their rear surfaces to reduce their thickness to 100 to 300 µm after producing IC circuits on them, since the IC wafers thicker than 500 µm are too thick for a regulation plate for restricting deformation of flexibly deformable portions of displacement detection devices. A waterproof sheet is bonded on a surface with IC circuit to protect the IC circuit and the rear surface of the IC wafer is ground by a diamond grinding wheel, while pouring a grinding coolant. The ground surface roughness is about 0.1 µm to 0.2 µm in Rmax. It is known from experience that there is a relationship between the surface roughness on the rear surface of the IC wafer and chipping appearance frequency on side ridges after dicing into IC chips, and the coarser the surface roughness, the more the chippings caused on the side ridges. If the rear surface is polished to reduce chippings, the polishing is machining-hour consuming but also increases the temperature of the IC wafer to hurt the IC circuit function. By the reason, not polishing but grinding is adopted. Also, because a thinned IC wafer is rarely handled with suctioning, a polished surface is not necessary for handling but a ground surface is enough.

In the displacement detection device according to the present invention, it is preferable that the grinding traces on the rear surface of the IC chip are at an angle of 10 to 45 degrees with the vertical line on the side ridges of the IC chip.

Forming grinding traces at an angle of 10 degrees to 45 degrees with a vertical line on side ridges of the IC chip can drastically reduce the number of chippings including loose chippings caused on the side ridges. Chipping appearance frequency for grinding traces at an angle less than 10 degrees with a vertical line is reduced to about 1/20 in comparison with the cases more than 45 degrees. When the rear surface roughness is improved to that of a polished surface of less than 0.01 µm in Rmax, the chipping appearance frequency even for a grinding trace angle more than 45 degrees reduces, but it is almost constant in a rear surface roughness range of Rmax 0.05 to 0.2 µm. By the reason, chippings including loose chippings caused on side ridges can be reduced by controlling the angle of grinding traces with the dicing direction on dicing IC wafers having a ground surface on the rear surface.

In a displacement detection device using a rectangular IC chip, it is preferable that the grinding traces of the rear surface of the IC chip are at an angle of 0 to 45 degrees with a vertical line on one of the side ridges of the rectangular IC chip, and that side ridges perpendicular to the one of the side ridges are bonded to the displacement detection element by adhesive.

When grinding traces of a rear surface of a rectangular IC chip are at an angle of 0 degrees to 45 degrees with a vertical line on one of side ridges of the IC chip, loose chipping appearance ratio can be reduced for the one of the side ridges. The rectangular IC chip has other side ridges at an angle of 90 degrees with the one of the side ridges. Then, the other side ridges of the rectangular IC chip might have an increased appearance ratio of loose chippings. Bonding the other side ridges by adhesive can prevent silicon broken pieces from removing from loose chippings caused on the other rear ridges. In the case, the chipping appearance ratio can be reduced to almost zero, when the grinding traces on the rear surface of the IC chip are at an angle of 20 degrees to 45 degrees with a vertical line on the one of the side ridges.

It is preferable that the IC chip is rectangular, and that the grinding traces of the rear surface of the IC chip are at an angle of 0 degrees to 20 degrees with the vertical line on the one of the side ridges of the rectangular IC chip.

When grinding traces of the rear surface of the rectangular IC chip are at an angle of 0 degrees to 20 degrees with a vertical line on the one of the side ridges of the rectangular IC chip, the other side ridges of the IC chip have the grinding traces of the rear surface of the IC chip at an angle of 70 degrees to 90 degrees with a vertical line. Since loose chipping appearance ratio is low for the grinding traces at angles of 0 degrees to 20 degrees or 70 degrees to 90 degrees with a vertical line on a side ridge, silicon broken pieces caused by loose chippings can be avoided.

Since IC circuit patterns cannot be disregarded to cut into IC chips, IC wafers are set on a grinding machine to direct the grinding direction of the IC wafers in a predetermined direction with respect to the dicing direction. When using a rotary grinding machine, the grinding directions change from an outside periphery of the grinding table to an inside periphery, if the IC wafers are set in the same direction. It is desirable to set the IC wafers on the grinding table in different directions depending on radial positions to make the grinding traces in a predetermined direction.

Chippings including loose chippings caused on side ridges of IC chips can be reduced by controlling an angle of grinding traces of rear surfaces of IC chips with an IC chip dicing direction. Using IC chips having loose chippings on side ridges as regulation plates can be avoided, and a highly reliable displacement detection device has been accomplished.

### BRIEF DESCRIPTION OF THE DRAWINGS

FIG. 1 shows a perspective schematic view of an IC chip for explaining an angle of grinding traces with a vertical line in the present invention and chippings;

FIG. 2 is a graph showing a relationship between chipping appearance ratio (%) and angles of grinding traces with a vertical line in the present invention;

FIG. 3 is an exploded perspective view of an acceleration sensor of EXAMPLE 2;

FIG. 4 is a cross-sectional view taken along the line IV - IV in FIG. 3 showing the acceleration sensor of EXAMPLE 2;

FIG. 5A and FIG. 5B are perspective views of acceleration sensor elements for an acceleration sensor of EXAMPLE 3;

FIG. 6 is a perspective view of an acceleration sensor device, in which an acceleration sensor and an IC are mounted on a substrate;

FIG. 7 is a cross-sectional view of an acceleration sensor having a regulation plate in prior art; and

FIG. 8 is a view showing a schematic structure of a pressure sensor using an IC chip as a regulation plate in prior art.

### DETAILED DESCRIPTION OF THE PREFERRED EMBODIMENTS

Embodiments of the present invention are described in detail below, referring to the accompanied drawings, in which same numeral references are used for same parts for convenience of understanding.

### EXAMPLE 1

A relationship between an angle of grinding traces with a dicing direction of IC wafers and chipping appearance frequency will be explained below. First of all, methods of grinding and dicing and conditions for taking data are described. After reducing thickness of IC wafers from 625 µm to 250 µm in silicon thickness by grinding, the wafers were cut into IC chips of 2.6 mm X 2.2 mm by a diamond dicing wheel. A waterproof sheet was bonded onto an IC circuit surface to protect the IC circuit from a grinding coolant for grinding. The grinding was done by a rotary grinding machine with a diamond grinding wheel of #2000 at a revolution speed of about 6000 rpm. The surface roughness of the ground surface was 0.13 µm in Rmax and 0.014 µm in Ra. Rmax and Ra were measured according to JIS B 0601. Since a thickness of the IC circuit was about 5 µm, the thickness to cut was about 255 µm. The IC wafer was bonded to an adhesive sheet, and the IC wafer was diced until a half of the adhesive sheet was cut. The dicing was done by a diamond dicing wheel of #3000 at a high speed revolution of about 30,000 rpm to 40,000 rpm. A grinding coolant was poured during the dicing.

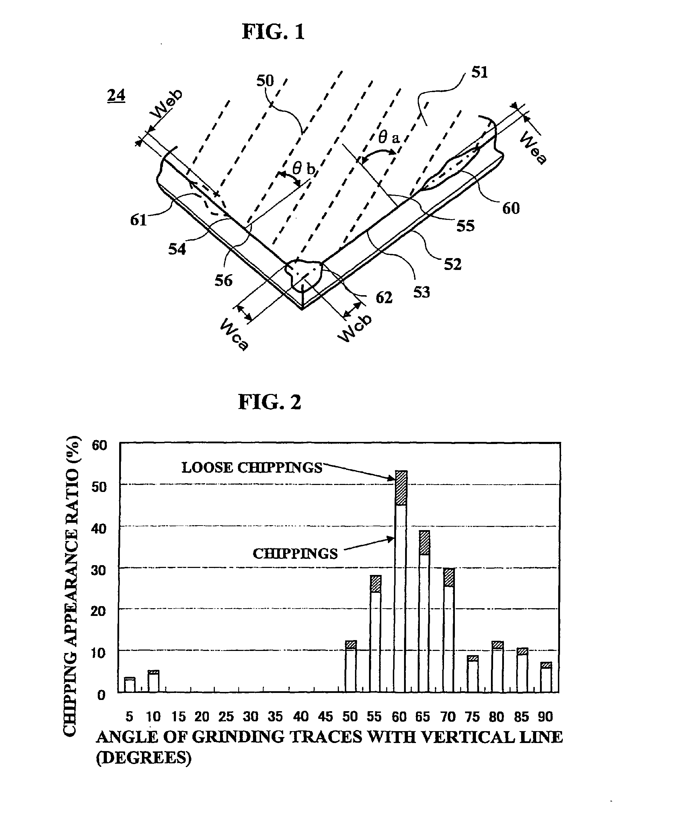

FIG. 1 shows angles of grinding traces with vertical lines and shapes of chippings. Since IC wafers are arranged from an inside periphery of a rotary table of the rotary grinding machine to an outside periphery and ground, grinding traces 50 distributing from an angle of 0 degrees to 90 degrees with a vertical line on aside ridge of IC chips were obtained after dicing into IC chips by a dicer. When IC wafers are ground by a rotary grinding wheel with a rotation axis on a secant line apart from a center of a rotary grinding table in the rotary grinding machine, the IC wafers set on an inner radial side on the rotary grinding table have, in general, grinding traces larger than those set on an outer radial side. An angle of grinding traces 50 with a vertical line 55 on a side ridge 53 of an IC chip 24 is shown by Oa, while an angle of grinding traces 50 with a vertical line 56 on a side ridge 54 of the IC chip 24 is shown by Ob. About 100,000 pieces of IC chips were investigated in angles of grinding traces with a vertical line on a side ridge and chippings. The number of side ridges investigated was four times the number of the IC chips, that is, 400,000 side ridges. The angles of grinding traces with the vertical line on the side ridges were classified to 0 to 5 degrees, 6 to 10 degrees, - - - , 85 to 90 degrees with intervals of 5 degrees, and chipping appearance ratio was obtained for every 5-degree interval.

As shown in FIG. 1, chippings only on a silicon substrate side 51, that is, on a rear surface side of IC chips 24 were counted, but those on an IC circuit side 52 were ignored. Chippings were defined as those having a defect width more than 3 gm perpendicular (in a direction apart from side ridges on a silicon substrate surface and in a thickness direction) to side ridges 53, 54 of the silicon substrate on the IC chip 24, and it was investigated whether or not the chippings were on the side ridges. Defect width of chippings 60 and loose chippings 61 caused on the side ridges were represented by Wea and Web, respectively, and defects more than 3 gm in these sizes were treated as chippings. Chippings 62 at a corner were also shown by a defect width Wca from a side ridge and a defect width Web from a side ridge. When a defect width Wca was more than 3 µm from the side ridge 53 and a defect width Wcb was less than 3 µm from the side ridge 54, the chipping 62 was on the side ridge 53 but not on the side ridge 54. When Wca and Wcb both were more than 3 µm, the chipping exists on both the side ridges 53 and 54. Since each of chippings should be classified to loose chippings and chippings, a side ridge having a loose chipping and a chipping was counted to both.

FIG. 2 shows a relationship of chipping appearance ratio in a vertical line and an angle of grinding traces with a vertical line in a horizontal line. The angle of 0 to 5 degrees of grinding traces with the vertical line is represented by 5 degrees, 5 to 10 degrees by 10 degrees,····, 85 to 90 degrees by 90 degrees. The chipping appearance ratio is shown by the number of side ridges having chippings divided by the number of inspected side ridges, in percentage. The chipping appearance ratio was separated into chippings (white) and loose chippings (slant lines). As apparent from FIG. 2, about 5 % chippings appeared for grinding trace angles from 0 to 10 degrees. For grinding trace angles from 10 to 45 degrees, the chipping appearance ratio was 0 %. When the grinding trace angle reaches more than 45 degrees, the chippings started to appear. The appearance ratio is at the maximum at angles of 55 to 60 degrees and shows 53 %. It was recognized that there was an angle range where chippings hardly appear. The number ratio of loose chippings to chippings was about 1/8 regardless of grinding trace angle.

It is understood from the result that the angle of the grinding traces with the vertical line is desirably from 10 degrees to 45 degrees. When the angle is from 0 degrees to 10 degrees, the chipping appearance ratio is about at 5 % that is very low comparing to a chipping appearance ratio of the case more than 45 degrees. In comparison to a displacement detection device manufactured regardless of angle of the grinding traces, a very reliable displacement detection device can be obtained when using IC chips having grinding traces of from 0 degrees to 45 degrees.

Chippings at issue for a displacement detection device are loose chippings, in which silicon broken pieces are left at defected portions. During assembling or using displacement detection devices, the silicon broken pieces drop from the loose chippings and affect properties of the displacement detection devices. From the result of this EXAMPLE, it is understood that the total number of the loose chippings becomes to about 1/20 in comparison with loose chipping number when manufactured regardless of grinding trace angle, and the number of the loose chippings is zero in a case of grinding trace angle of 10 degrees to 45 degrees. In other words, a problem ratio becomes to 1/20 when the grinding trace angle is less than 45 degrees, and further the problem ratio reduces to zero by using the grinding trace angle of 10 degrees to 45 degrees.

A side ridge 53 is perpendicular to another side ridge 54 in a rectangular IC chip 24 shown in FIG. 1. When grinding traces 50 are at an angle of 0 degrees to 20 degrees with a vertical line 55 on the side ridge 53, the grinding traces 50 are at an angle of 90 degrees to 70 degrees with a vertical line 56 on the other side ridge 54. Chipping appearance ratio on the side ridge 53 is less than 5 %, and chipping appearance ratio on the side ridge 54 is at most 12 %. Even when a chipping preventive, such as bonding with adhesive, is not taken on side ridges of the rectangular IC chip, appearance ratio of loose chippings can be further reduced when grinding traces on a side ridge are at an angle of 0 degrees to 20 degrees with a vertical line on the side ridge, because chipping appearance ratio including the other side ridge can be restricted to at most 12 %.

### EXAMPLE 2

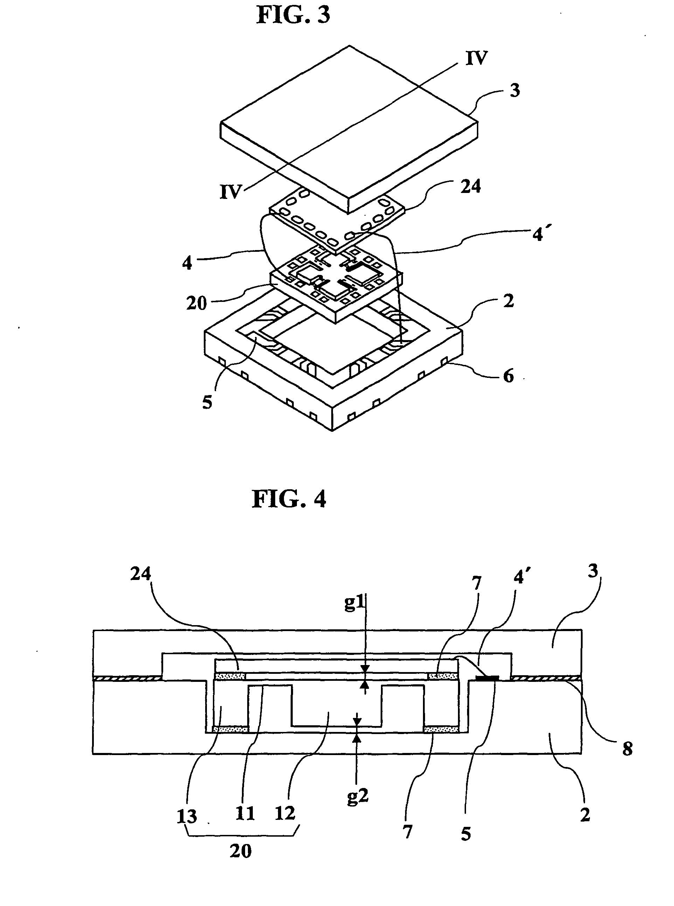

Using IC chips having loose chippings, acceleration sensors that are a kind of displacement detection devices were assembled. An exploded perspective view of the assembled acceleration sensor is shown in FIG. 3. In FIG. 3, an acceleration sensor element 20 is electrically connected to an IC chip 24 by lead wires 4, and the IC chip 24 is connected by wires 4' to terminals 5 of a protection case 2 and to external terminals 6. An acceleration sensor 10 is assembled with a protection case lid 3 fixed on and sealed with the protection case 2. Piezo resistors of the acceleration sensor element 20 are omitted from the drawing. FIG. 4 shows a cross-sectional view taken along the line IV - IV of FIG. 3. The acceleration sensor element 20 is composed of a weight 12, a support frame 13 and flexibly deformable portions 11. Piezo resistors (not shown) connected with the lead wires 4 are formed on surfaces of the flexibly deformable portions 11. The IC chip 24 is disposed for a rear surface of the IC chip to face the flexibly deformable portions (or arms) 11 of the acceleration sensor element 20 with a predetermined gap g1 from the flexibly deformable portions and to restrict an excessive movement of the flexibly deformable portions. The IC chip 24 receives a signal from the piezo resistors and processes the signal. The support frame 13 and the protection case lid 3 are bonded to the protection case 2 by adhesive 7 and 8, respectively. When an external force is applied to the acceleration sensor element 20, the weight 12 hanging from the flexibly deformable portions 11 is moved to bend the flexibly deformable portions 11, and the piezo resistors sense the bending amount and produce electric voltage.

Using 300 pieces of IC chips with loose chippings 61, as shown in FIG. 1, of 3 µm to 63 µm in width Web, acceleration sensors (Sample A) having loose chippings were assembled. The loose chippings were distributed from 19 µm to 367 µm in length. For comparison, acceleration sensors (Sample B) of the same number having no loose chippings were assembled.

The acceleration sensors of Sample A and Sample B were set on a vibrator to apply acceleration of 20 G to them, and output voltages from them were measured. Excluding acceleration sensors that showed extraordinary output, the acceleration sensors were freely fallen five times from a height of 1 meter to a wooden board of 100 mm thick, output from the acceleration sensors were measured during applying acceleration of 20 G, and the number of acceleration sensors showing extraordinary output was counted. When an acceleration sensor is freely fallen from the above-mentioned height, an impact of about 1500 G to 2000 G is applied to the acceleration sensor, and the flexibly deformable portions of the acceleration sensor element collide with a rear surface of an IC chip.

In the measurement of the acceleration sensors before the free fall, three pieces of Sample A and one piece of Sample B showed extraordinary output. By disassembling the acceleration sensors and investigating, it was revealed that silicon broken piece was trapped between a bottom of the weight of the acceleration sensor element and an inner bottom of the protection case in two pieces among the three of Sample A. It was recognized from comparison in shape that the silicon broken piece was fallen from loose chippings of the IC chip. Since an excessive impact was not applied to the acceleration sensors, it is considered that the silicon broken piece dropped during assembling by any reason. It is thought that remaining one piece of Sample A and the one of Sample B were injured on the flexibly deformable portions during assembling, and loose chippings of the IC chips were not a cause.

After 297 pieces of Sample A and 299 pieces of Sample B, excluding the initial-accidental products, were applied to by a falling impact, one piece of Sample A produced an extraordinary output, but none of Sample B did. It was revealed from disassembling to investigate the acceleration sensor showing the extraordinary output that a silicon broken piece dropped from the IC chip and was trapped between a top of flexibly deformable portions and a rear surface of the IC chip. The silicon broken piece trapped was 20 µm X 18 µm X 170 µm in dimension. The sensor was built to have a gap g1 of 15 µm between the top of the flexibly deformable portions and the rear surface of the IC chip. It is thought that, when an applied impact worked to move the weight down and to expand the gap, the silicon broken piece was trapped in the gap and was left there. An investigation did not show whether the drop of the silicon broken piece was caused by a collision with the flexibly deformable portions at the impact or only by the impact. It was confirmed from the result that loose chippings of the IC chip are one of the causes for problems that happen on using an acceleration sensor. Since one piece among 297 pieces of the acceleration sensors assembled with an IC chip having loose chippings had a problem, the problem appearance ratio was 1/297.

From the results of EXAMPLE 1 and EXAMPLE 2, the number of acceleration sensors, which would have a problem caused by a drop of loose chippings from an IC chip after product delivery, is presumed below. Appearance ratio of chippings on side ridges is 12.4 % among 100,000 pieces of IC chips manufactured regardless of grinding trace angle. As explained above, loose chippings to all chippings are 11.1 %, and the appearance ratio of problem caused by a drop of loose chippings during the use of acceleration sensors is 1/297=0.33 %. Then, 100,000 pieces X 12.4 % X 11.1 % X 0.33 % equals to 4.5 pieces. This means that there is a risk of causing problems of 4.5 pieces among 100,000 pieces of conventional acceleration sensors with IC chips manufactured regardless of grinding trace angle. By contrast, the appearance ratio of problems caused by the loose chippings during the use can be made almost zero by using IC chips according to the present invention regulating an angle of the grinding traces with the dicing direction in the IC chips, and more reliable acceleration sensors can be supplied. In the same manner as the acceleration sensor, pressure sensors and gyro-sensors were studied, and results of them were almost the same as the acceleration sensor.

### EXAMPLE 3

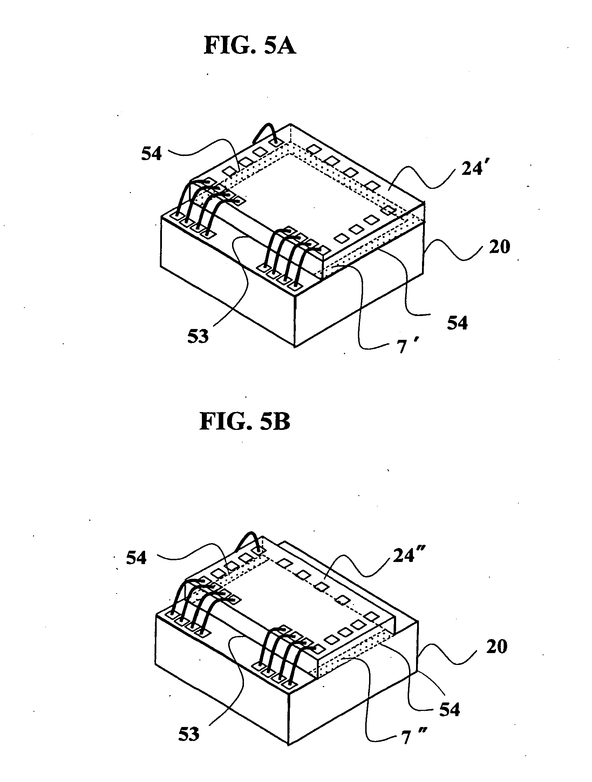

FIG. 5A and FIG. 5B show acceleration sensor elements for acceleration sensors of EXAMPLE 3 by perspective views. An IC chip 24' is fixed on an acceleration sensor element 20 in FIG. 5A with three side ridges of the rectangular IC chip 24' bonded to a support frame by adhesive 7'. On the top surface of the IC chip 24', an IC circuit is formed, and a rear surface (a surface facing the acceleration sensor element 20) of the IC chip 24' is ground to have a predetermined thickness in the same manner as shown in FIG. 1 and grinding traces at an angle of 15 degrees to 30 degrees with a vertical line on the side ridge 53. The side ridge 53 having the grinding traces at the angle of 15 degrees to 30 degrees with the vertical line does not have chippings on it, as explained in EXAMPLE 1. Since side ridges 54 perpendicular to the side ridge 53 have grinding traces at an angle of 75 degrees to 60 degrees with a vertical line, the side ridges 54 show loose chipping appearance ratio of 5 to 6 % as apparent from the graph of FIG. 2. Three side ridges, including the two side ridges 54 showing loose chipping appearance ratio of 5 to 6 %, are bonded by adhesive 7' to fix loose chippings on the side ridges 54 by the adhesive, and the loose chippings will not drop during the production and the use.

In FIG. 5B, an IC chip 24" is supported on an acceleration sensor element 20 so that two side ridges 54 of the rectangular IC chip 24" are bonded onto a support frame of the acceleration sensor element by adhesive 7". The IC chip 24" has on its rear surface grinding traces at an angle of 15 degrees to 30 degrees with a vertical line on side ridges 53 in the same way as the IC chip 24' explained above. The side ridges 53 have no chippings. Since the grinding traces are at an angle of 75 degrees to 60 degrees with a vertical line on the side ridges 54 perpendicular to the side ridges 53, loose chipping appearance ratio on the side ridges 54 is 5 to 6 %. But, since the side ridges 54 are bonded onto the support frame by adhesive 7", there is no risk of the loose chippings dropping from the side ridges during the production or the use of the sensor.

In the acceleration sensor of EXAMPLE 3, a risk of accident appearance can be made smaller than the acceleration sensor of EXAMPLE 2.
Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A displacement detection device comprising:
a displacement detection element (20) having a flexibly deformable portion to be deformed by an external force and measuring a displacement of the flexibly deformable portion to emit a detection signal;
an IC chip (24) having an electronic circuit for electrically processing the detection signal from the displacement detection element (20) and disposed for a rear surface of the IC chip (24) to face the flexibly deformable portion with a predetermined gap from the flexibly deformable portion to mechanically prevent the flexibly deformable portion from excessively deforming; and
a protection case (2) housing the displacement detection element (20) and the IC chip (24);
**characterized in that**
the IC chip is rectangular, the grinding traces on the rear surface of the IC chip (24) are at an angle of 0 to 45 degrees with a vertical line on one of side ridges of the rectangular IC chip (24), and side ridges perpendicular to the one of the side ridges are bonded to the displacement detection element by adhesive.

2. A displacement detection device as set forth in claim 1,
wherein the grinding traces on the rear surface of the IC chip (24) are at an angle of 10 to 45 degrees with the vertical line on the one of the side ridges of the rectangular IC chip (24).

## Patentansprüche

1. Verschiebungsdetektor mit:
einem Verschiebungsdetektionselement (20), das einen elastisch verformbaren Abschnitt, der von einer äußeren Kraft zu verformen ist, aufweist und die Verschiebung des elastisch verformbaren Abschnitts misst, um ein Detektionssignal auszugeben; einem IC-Chip (24), der eine elektronische Schaltung zum elektrischen Verarbeiten des Detektionssignals von dem Verschiebungsdetektionselement (20) aufweist und angeordnet ist, damit eine hintere Oberfläche des IC-Chips (24) dem elastisch verformbaren Abschnitt mit einer vorgegebenen Lücke von dem elastisch verformbaren Abschnitt zugewandt ist, um mechanisch zu verhindern, dass der elastisch verformbare Abschnitt übermäßig verformt wird; und
einem Schutzgehäuse (2), das das Verschiebungsdetektionselement (20) und den IC-Chip (24) umgibt;
**dadurch gekennzeichnet, dass**
der IC-Chip rechteckig ist, die Schleifmarken auf der hinteren Oberfläche des IC-Chips (24) in einem Winkel von 0 bis 45 Grad zu einer vertikalen Linie auf einem der Seitengrate des rechtekkigen IC-Chips (24) verlaufen und Seitengrate, die zu dem einen der Seitengrate senkrecht verlaufen, durch ein Klebemittel mit dem Verschiebungsdetektionselement verbunden sind.

2. Verschiebungsdetektionselement nach Anspruch 1,
wobei die Schleifmarken auf der hinteren Oberfläche des IC-Chips (24) in einem Winkel von 10 bis 45 Grad zu der vertikalen Linie auf dem einen der Seitengrate des rechteckigen IC-Chips (24) verlaufen.

## Revendications

1. Dispositif de détection de déplacement comprenant :
un élément de détection dé déplacement (20) possédant une partie élastiquement déformable devant être déformée par une force externe et mesurant un déplacement de la partie élastiquement déformable pour émettre un signal de détection ;
une puce de CI (24) possédant un circuit électronique permettant de traiter électriquement le signal de détection provenant de l'élément de détection de déplacement (20) et disposée de manière à ce qu'une surface arrière de la puce de CI (24) se trouve face à la partie élastiquement déformable avec un espacement défini au préalable par rapport à la partie élastiquement déformable afin d'empêcher mécaniquement la partie élastiquement déformable de se déformer de manière excessive ; et
un boîtier de protection (2) renfermant l'élément de détection de déplacement (20) et la puce de CI (24) ;
**caractérisé en ce que**
la puce de CI est rectangulaire, les traces de meulage sur la surface arrière de la puce de CI (24) déterminent un angle pouvant aller de 0 à 45 degrés avec une ligne verticale sur l'une des arêtes latérales de la puce de CI rectangulaire (24), et les arêtes latérales perpendiculaires à l'une des arêtes latérales sont fixées à l'élément de détection de déplacement au moyen d'un adhésif.

2. Dispositif de détection de déplacement tel que présenté dans la revendication 1,
dans lequel les traces de meulage sur la surface arrière de la puce de CI (24) déterminent un angle de 10 à 45 degrés avec la ligne verticale sur l'une des arêtes latérales de la puce de CI rectangulaire (24).
